Europäisches Patentamt

European Patent Office

Office européen des brevets

(11) Publication number: **0 271 247**
**A2**

(12) # EUROPEAN PATENT APPLICATION

(21) Application number: 87310337.8

(22) Date of filing: 24.11.87

(51) Int. Cl.4: **H01L 21/203** , H01L 21/20 , H01L 29/78 , H01L 29/08

(30) Priority: 04.12.86 JP 289162/86

(43) Date of publication of application:
**15.06.88 Bulletin 88/24**

(84) Designated Contracting States:
**DE FR GB**

(71) Applicant: SEIKO INSTRUMENTS INC.
31-1, Kameido 6-chome Koto-ku
Tokyo 136(JP)

(72) Inventor: Aoki, Kenji
c/o Seiko Instruments Inc. 31-1, Kameido
6-chome
Koto-ku Tokyo(JP)
Inventor: Shinbo, Masafumi
c/o Seiko Instruments Inc. 31-1, Kameido
6-chome
Koto-ku Tokyo(JP)

(74) Representative: Caro, William Egerton et al
J. MILLER & CO. Lincoln House 296-302 High
Holborn
London WC1V 7JH(GB)

(54) **A MOS field effect transistor and a process for fabricating the same.**

(57) A MOS field effect transistor comprises a substrate (1) of a first conductivity type, source and drain regions of a second conductivity type having a lightly doped region and a heavily doped region therein being deposited by an epitaxial growth technique respectively in a source forming region (4) and a drain forming region (3) formed by etching the substrate, a gate insulated film (2) provided on a surface of the substrate (1) and a gate (5) provided on the gate insulated film having a relatively small overlap with each of the source region and drain region.

FIG.1(b)

FIG.1(c)

FIG.1(d)

# A MOS FIELD EFFECT TRANSISTOR AND A PROCESS FOR FABRICATING THE SAME

This invention relates to MOS field effect transistors and to processes for fabricating the same.

Miniaturisation techniques are indispensable for improving the efficiency and performance of semiconductor devices. However, one of the problems in miniaturising an insulated gate field effect transistor (MOS FET) with an extremely short channel length is the "short channel effect" by which threshold voltage is lowered. This is caused because the effective length of the channel is shortened as a result of spreading a depletion region towards a gate from a drain region. In order to prevent the short channel effect, the following measures are provided: (i) the impurity concentration in the channel region is increased; and (ii) the thickness of source/drain diffusion layers and their horizontal extension of diffusion towards the gate are decreased.

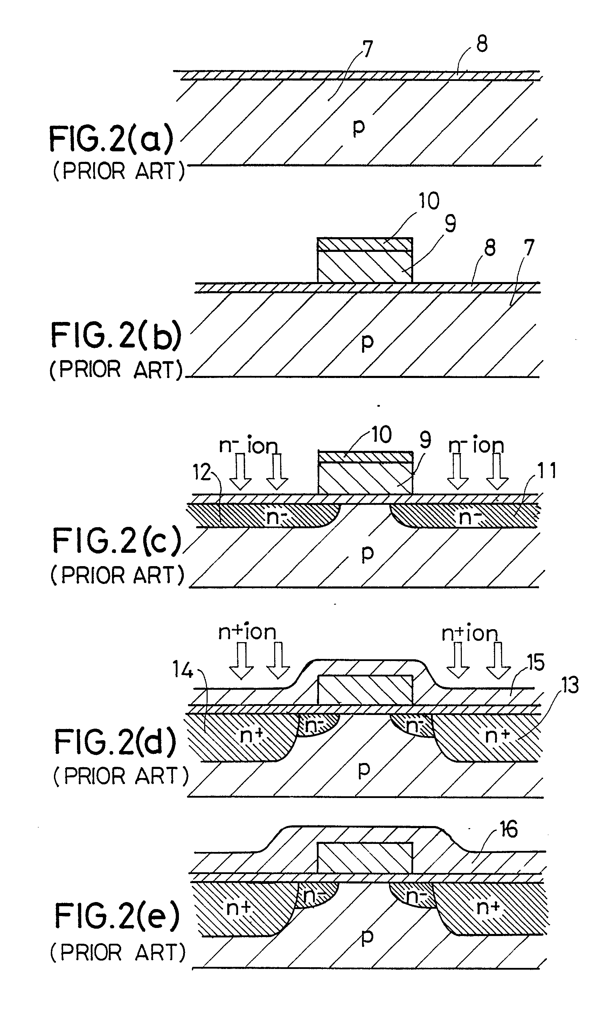

In the light of the above, a MOS field effect transistor having an LDD (lightly doped drain) structure has conventionally been fabricated by a process shown in Figures 2(a) to 2(e). After surface oxidation of, for example, a P-type substrate 7, a polysilicon layer 8 is deposited and a gate 9 is formed by using a photo resist 10, as shown in Figure 2(a) and Figure 2(b). In Figure 2(c), n-ion implantation and thereafter annealing (generally at 1000 - 1200°C) are carried out to form lightly doped regions 11,12. At this stage thermal diffusion occurs towards the region under the gate. Figure 2-(d) shows a step in which, after the photo resist 10 is removed, a mask film 15 for ion implantation is deposited by chemical vapour deposition (CVD), and n+ ion implantation is carried out to form n+ regions 13,14. The mask film 15, damaged by the ion implantation, is removed and then an oxide film 16 is deposited as shown in Figure 2(e).

However, the conventional process as described above is not fully satisfactory. Since at the step shown in Figure 2(c) ion implantation and then annealing is carried out generally at 1000 - 1200°C, three-dimensional diffusion defined by the ion acceleration energy and annealing temperature cannot be avoided, and consequently there are limitations in terms of the control of diffusion depth. It is, therefore, extremely difficult or almost impossible to control diffusion depth with a degree of accuracy of the order of 1000 Å or less.

The present invention seeks to provides a MOS field effect transistor with source and drain regions each having a lightly doped region and a heavily doped region therein which are deposited through the use of an epitaxial growth technique.

According to one aspect of the present invention there is provided a MOS field effect transistor characterised by comprising: a substrate of a first conductivity type; a drain region of a second conductivity type having a lightly doped region and a heavily doped region therein being deposited by an epitaxial growth technique in a drain forming region formed by etching said substrate; a source region of the second conductivity type in said substrate; a gate insulated film provided on the surface of said substrate; and a gate provided on said gate insulated film having a relatively small overlap with each of said source region and drain region.

According to another aspect of the present invention there is provided a MOS field effect transistor characterised by comprising: a substrate of a first conductivity type; source and drain regions of a second conductivity type having a lightly doped region and a heavily doped region therein being deposited by an epitaxial growth technique respectively in a source forming region and a drain forming region formed by etching said substrate; a gate insulated film provided on the surface of said substrate; and a gate provided on said gate insulated film having a relatively small overlap with each of said source region and drain region.

Preferably said relatively small overlap is 500 Å or less.

According to another aspect of the present invention there is provided a process for fabricating a MOS field effect transistor characterised by comprising: a first step of thermally oxidising a surface of a substrate of a first conductivity type to form an oxide film: a second step of, after patterning, etching said surface to form a gate insulated film. a source forming region and a drain forming region in said substrate; a third step of epitaxially depositing layers of a second conductivity type in said source forming region and said drain forming region using an epitaxial growth technique to form source and drain regions of the second conductivity type having a lightly doped region and a heavily doped region therein; a fourth step of depositing a layer of a relatively high melting point material on said oxide film and said source and drain regions; and a fifth step of, after patterning, etching said layer to form a gate on said gate insulated film.

Said epitaxial growth technique may comprise a molecular beam epitaxial growth technique carried out at a temperature of 850°C or less.

Said lightly doped region and heavily doped region may be provided by controlling the concentration of impurity concurrently whilst said epitaxial growth technique is being carried out.

In one embodiment said etching to form said source forming region and/or said drain forming region comprises an anisotropic etching technique such as reactive ion etching.

The invention is illustrated, merely by way of example, in the accompanying drawings, in which:-

Figures 1(a) to 1(d) are sectional views illustrating schematically a process according to the present invention for fabricating a MOS field effect transistor having an LDD structure;

Figures 2(a) to 2(e) are sectional views illustrating schematically a conventional process for fabricating a MOS field effect transistor having an LDD structure;

Figure 3 is a cross-section representing source and drain regions and gate of a MOS field effect transistor according to the present invention; and

Figure 4 shows an example of impurity distribution in the direction of arrow X taken along the line A-A' in Figure 3.

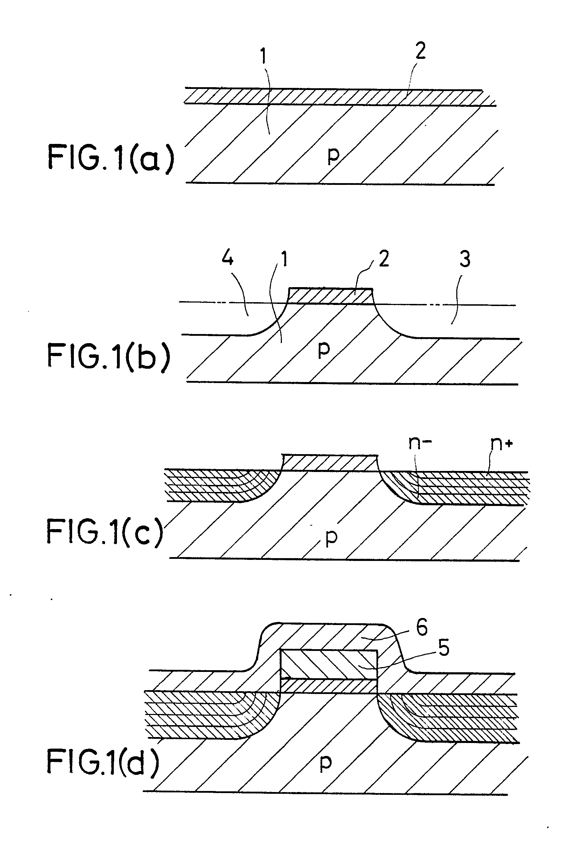

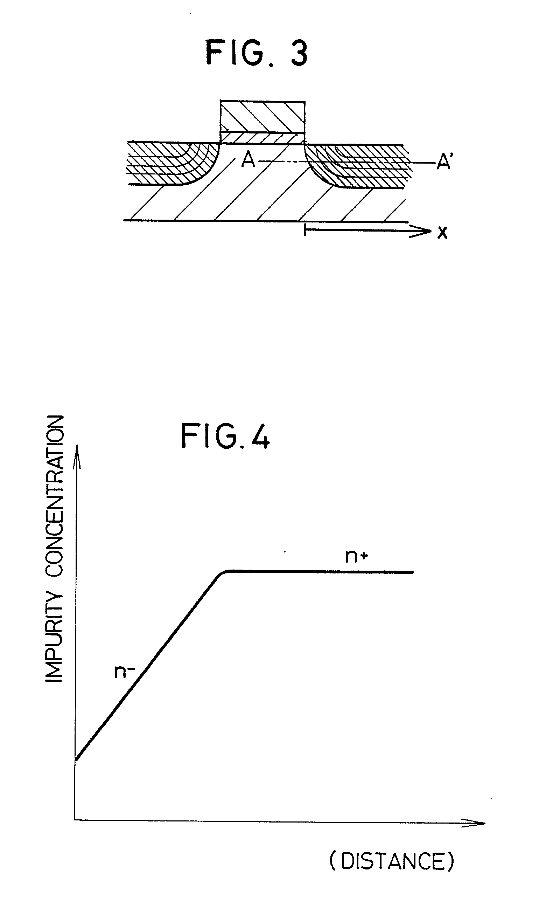

Referring to Figure 1(a) there is illustrated one embodiment of a process according to the present invention for fabricating a MOS field effect transistor having an LDD structure. The surface of a P-type substrate 1 is thermally oxidised to form an oxidised film 2. After patterning, the surface of the substrate is etched by an anisotropic etching such as a reactive ion etching technique to form a source forming region 4 and a drain forming region 3, whilst leaving a gate insulated film 2, as shown in Figure 1(b). Figure 1(c) shows a step in which layers are selectively grown at 850°C or less by a molecular beam epitaxial growth technique whilst impurity doping concentration of the layers is adjusted by controlling the supply of an impurity source gas so that the impurity concentration has a distribution such as that shown in Figure 4 in the direction of arrow X along the line A-A' in Figure 3.

A molecular beam epitaxial growth technique by which a single crystal can be grown at temperatures of 850°C or less in units of an atomic layer is used to form a source region and a drain region. Since the growth temperature is 850°C or less, auto-doping and thermal diffusion are remarkably small. Further, a lightly doped region and a heavily doped region are provided during the foregoing epitaxial growth technique in order to reduce the short channel effect which is a phenomenon presented in very small semiconductor devices having an extremely short channel length.

On completing the deposition of the layers forming the source and drain regions, a layer of polysilicon or other high melting point material such as, for example, molybdenum silicide or tungsten silicide is deposited, patterning is carried out, and then a gate 5 is formed by etching. Finally, an oxide film 6 is deposited, as shown in Figure 1(d). The longitudinal diffusion depth of the source and drain regions and the horizontal diffusion depth towards the region under the gate are defined by the thermal diffusion temperature of the substrate. Since the impurity layers are deposited at 850°C or less by a molecular beam epitaxial growth technique, thermal diffusion is negligible compared with the conventional ion implantation technique accompanied by annealing.

The process according to the present invention and described above is such that an impurity doped layer having a lightly doped region and a heavily doped region is formed at least in the drain region concurrently with the epitaxial growth of the layer to form an LDD structure. The source and drain regions are deposited by an epitaxial growth technique at temperatures of 850°C or less with the result that the thickness of the epitaxial growth layer can be controlled with a degree of accuracy of the order of an atomic layer. Thus it is is possible to fabricate a MOS field effect transistor with an impurity doped layer having an impurity concentration distribution which cannot be formed by the conventional process utilising ion implantation. The combination of the epitaxial growth technique and the LDD structure enables the spreading of the source and drain regions into the region under the gate to be controlled to 500 Å or less, and therefore the overlap of the gate with the source and drain regions is extremely small compared to that resulting from the conventional process. This feature is highly effective and important in terms of miniaturisation and results in a MOS field effect transistor with a higher operational speed and a lower power consumption. A MOS field effect transistor as described herein is also excellent in preventing fluctuation of semiconductor device characteristics due to generation of hot carriers which results from miniaturisation.

**Claims**

1. A MOS field effect transistor characterised by comprising: a substrate (1) of a first conductivity type; a drain region of a second conductivity type having a lightly doped region and a heavily doped region therein being deposited by an epitaxial growth technique in a drain forming region (3) formed by etching said substrate; a source region of the second conductivity type in said substrate; a gate insulated film (2) provided on the surface of said substrate (1); and a gate (5) provided on said gate insulated film (2) having a relatively small overlap with each of said source region and drain region.

2. A MOS field effect transistor characterised by comprising: a substrate (1) of a first conductivity type; source and drain regions of a second conductivity type having a lightly doped region and a heavily doped region therein being deposited by an epitaxial growth technique respectively in a source forming region (4) and a drain forming region (3) formed by etching said substrate; a gate insulated film (2) provided on the surface of said substrate (1); and a gate (5) provided on said gate insulated film (2) having a relatively small overlap with each of said source region and drain region.

3. A MOS field effect transistor as claimed in claim 1 or 2 characterised in that said epitaxial growth technique comprises a molecular beam epitaxial growth technique carried out at a temperature of 850°C or less.

4. A MOS field effect transistor as claimed in any preceding claim characterised in that said lightly doped region and heavily doped region are provided by controlling the concentration of impurity concurrently whilst said epitaxial growth technique is being carried out.

5. A MOS field effect transistor as claimed in any preceding claim characterised in that said relatively small overlap is 500 Å or less.

6. A MOS field effect transistor as claimed in any preceding claim characterised in that said etching to form said source forming region (4) and/or said drain forming region (3) comprises an anisotropic etching technique such as reactive ion etching.

7. A process for fabricating a MOS field effect transistor characterised by comprising: a first step of thermally oxidising a surface of a substrate (1) of a first conductivity type to form an oxide film; a second step of, after patterning, etching said surface to form a gate insulated film (2), a source forming region (4) and a drain forming region (3) in said substrate (1); a third step of epitaxially depositing layers of a second conductivity type in said source forming region (4) and said drain forming region (3) using an epitaxial growth technique to form source and drain regions of the second conductivity type having a lightly doped region and a heavily doped region therein; a fourth step of depositing a layer of a relatively high melting point material on said oxide film and said source and drain regions; and a fifth step of, after patterning, etching said layer to form a gate (5) on said gate insulated film (2).

8. A process as claimed in claim 7 characterised in that said epitaxial growth technique comprises a molecular beam epitaxial growth technique carried out at a temperature of 850°C or less.

9. A process as claimed in claim 7 or 8 characterised in that said lightly doped region and heavily doped region are provided by controlling the concentration of impurity concurrently whilst said epitaxial growth technique is being carried out.

10. A process as claimed in any of claims 7 to 9 characterised in that said etching to form said source forming region and/or said drain forming region comprises an anisotropic etching technique such as reactive ion etching.

FIG.1(a)

FIG.1(b)

FIG.1(c)

FIG.1(d)

FIG.2(a)
(PRIOR ART)

FIG.2(b)
(PRIOR ART)

FIG.2(c)
(PRIOR ART)

FIG.2(d)
(PRIOR ART)

FIG.2(e)
(PRIOR ART)

# FIG. 3

# FIG.4

IMPURITY CONCENTRATION

n+

n⁻

( DISTANCE)